# DEMANDE DE BREVET EUROPEEN

(11) **EP 0 735 802 A1**
(43) Date de publication de la demande: **02.10.1996**
(21) Numéro de dépôt: 96400643.1
(22) Date de dépôt: 27.03.1996
(51) Int. Cl.: H05B 41/29, H03K 17/691

(54) **Dispositif pour la commande d'un convertisseur continu/alternatif dans un dispositif d'alimentation de lampe à décharge de projecteur de véhicule automobile**

(30) Priorité: 29.03.1995 FR 9503730
(71) Demandeur: VALEO ELECTRONIQUE, 94000 Creteil (FR)
(72) Inventeur: Cassese, Bruno, 94000 Creteil (FR); Wacheux, Patrick, 94800 Villejuif (FR); Paul, Gilles, 92260 Fontenay aux Roses (FR); Nicolai, Jean-Marc, 92400 Courbevoie (FR); Herzberger, Eric, 93220 Gagny (FR)
(74) Mandataire: Le Forestier, Eric

(57) **Abrégé**

Dispositif pour la commande d'un convertisseur continu/alternatif d'un dispositif d'alimentation d'une lampe à décharge de projecteur de véhicule automobile, comportant un circuit primaire, des moyens pour l'alimentation en tension de ce circuit primaire, ainsi qu'un circuit secondaire couplé par induction mutuelle à ce circuit primaire, ce circuit secondaire délivrant à un interrupteur du convertisseur continu/alternatif une tension commandant sa fermeture ou son ouverture, caractérisé en ce que la tension que les moyens d'alimentation délivrent au circuit primaire consiste en une tension à porteuse haute fréquence modulée, le circuit secondaire comportant des moyens pour convertir la tension haute fréquence délivrée au circuit primaire en une tension de commande de l'interrupteur qui est supérieure ou inférieure à un seuil donné d'ouverture ou de fermeture, selon la modulation de ladite tension haute fréquence.

## Description

La présente invention est relative à un dispositif pour la commande d'un convertisseur continu/alternatif d'un dispositif d'alimentation d'une lampe à décharge de projecteur de véhicule automobile.

Il a été récemment proposé d'alimenter des lampes à décharge de véhicule automobile par des courants alternatifs de forme carrée d'une fréquence de l'ordre de 200 Hz à 1 kHz.

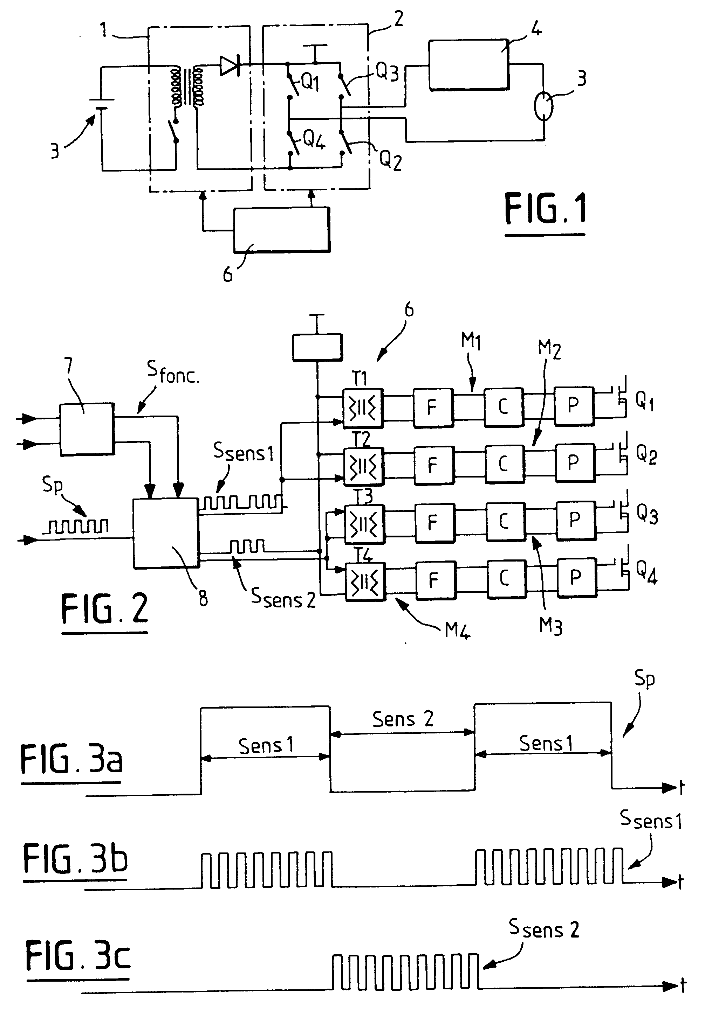

On a représenté sur la figure 1 un dispositif permettant une alimentation de ce type.

Ce dispositif comporte un convertisseur continu/continu 1 alimenté par la tension continue de la batterie B du véhicule, ainsi qu'un convertisseur continu/alternatif 2 monté entre le convertisseur 1 et la lampe à décharge 3 du projecteur. Un module 4 pour la génération d'une impulsion Haute Tension servant à l'amorçage de la lampe 3 est monté en série avec celle-ci.

Le convertisseur continu/alternatif 2 est constitué de quatre interrupteurs rapides Q1 à Q4 montés selon un pont en H et commandés par un dispositif de commande 6. Ces interrupteurs Q1 à Q4 sont par exemple des transistors de type MOS, dont le dispositif 6 commande la tension de grille. Ils doivent supporter des tensions isolées variant de 0 à 500 V dans la lampe à décharge, ainsi que des courants variant de 0 à 3A, avec des transitoires pouvant atteindre 10 A, pendant quelques centaines de microsecondes.

Ces contraintes imposent aux différents éléments du dispositif 6 qui commande ces interrupteurs Q1 à Q4 des dimensionnements importants. C'est notamment le cas des transformateurs que de tels dispositifs de commande comportent, ces transformateurs étant dimensionnés de façon à pouvoir supporter des tensions de 500 V.

Or, on cherche actuellement à réduire considérablement l'encombrement des circuits d'alimentation des lampes à décharge de façon à pouvoir les loger totalement dans les projecteurs, alors que jusqu'à présent les convertisseurs des circuits d'alimentation étaient à l'extérieur.

Un but de l'invention est donc de proposer un dispositif de commande, qui est d'une structure permettant d'alléger le dimensionnement de ses différents éléments.

Également, la structure selon l'invention permet, bien que le pont en H commute à 200 Hz (basse fréquence), une commutation d'un état à un autre dans un temps très court (inférieur ou de l'ordre de 1 Ns).

On connaît déjà par EP 477 587 la commande d'un demi-pont par des signaux haute fréquence. Les moyens de conversion y sont particulièrement complexes et nécessitent en particulier un pont redresseur à diodes du fait de la nature très particulière du signal haute fréquence.

Par ailleurs, il a déjà été proposé par EP 154 062 d'utiliser des signaux alternatifs présentant une fréquence de l'ordre de 50 KHz pour la commande d'alternateurs d'un pont en H.

L'invention propose quant à elle un dispositif pour la commande d'un convertisseur continu/alternatif d'un dispositif d'alimentation d'une lampe à décharge de projecteur de véhicule automobile, comportant un circuit primaire, des moyens pour l'alimentation en tension de ce circuit primaire, ainsi qu'un circuit secondaire couplé par induction mutuelle à ce circuit primaire, ce circuit secondaire délivrant à un interrupteur du convertisseur continu/alternatif une tension commandant sa fermeture ou son ouverture, caractérisé en ce que la tension que les moyens d'alimentation délivrent au circuit primaire consiste en une tension à porteuse haute fréquence modulée, le circuit secondaire comportant des moyens pour convertir la tension haute fréquence délivrée au circuit primaire en une tension de commande de l'interrupteur qui est supérieure ou inférieure à un seuil donné d'ouverture ou de fermeture, selon la modulation de ladite tension haute fréquence.

Par tension haute fréquence, on entend dans le présent texte les fréquences de l'ordre de ou supérieures à 300 kHz, les fréquences préférées étant de l'ordre de 2 MHz.

Comme on l'aura compris, le fait d'utiliser des tensions haute fréquence permet de diminuer fortement l'encombrement des transformateurs des dispositifs de commande conformes à l'invention.

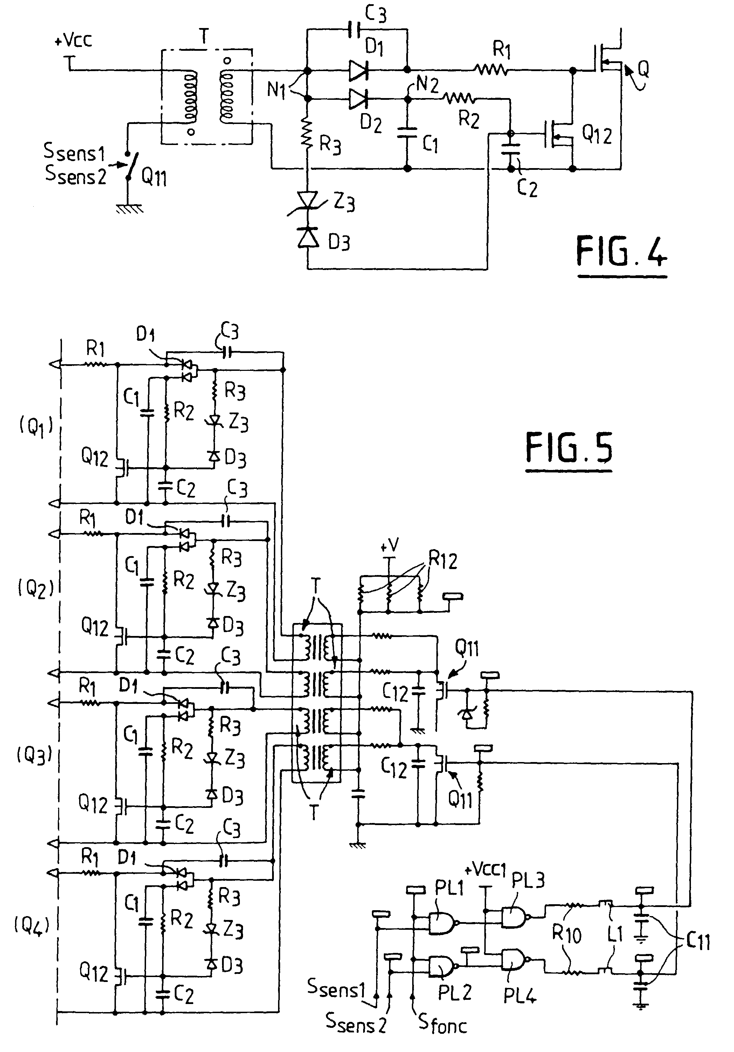

D'autres caractéristiques et avantages de l'invention ressortiront encore de la description qui suit. Cette description est purement illustrative et non limitative. Elle doit être lue en regard des dessins annexés sur lesquels :
. la figure 1, déjà analysée, est une représentation schématique d'un dispositif pour l'alimentation d'une lampe à décharge de projecteur de véhicule automobile ;
. la figure 2 est un schéma synoptique illustrant le principe d'un dispositif conforme à l'invention ;
. les figures 3a à 3c représentent des séquences de signaux mis en oeuvre par le dispositif de la figure 2;
. la figure 4 est un schéma d'un montage correspondant à une partie d'un dispositif conforme à un mode de réalisation possible pour l'invention ;
. la figure 5 est un schéma complet du montage d'un dispositif conforme à l'invention.

Le dispositif de commande 6 illustré sur la figure 2 comprend une unité logique 7 qui génère des signaux binaires de forme carrée S_{fonc.}, du type de celui représenté sur la figure 3a. Selon le sens de fonctionnement à commander pour le pont en H 3, un tel signal S_{fonc} est à un niveau ou à un autre.

Ces signaux S_{fonc} sont envoyés, avec une porteuse Haute Fréquence Sp également générée par l'unité logique 7, en entrée d'une unité de modulation 8. Les deux signaux S_{sens 1}, S_{sens 2} en sortie de cette unité 8 correspondent, ainsi qu'on l'a illustré sur les figures 3b et 3c, l'un à la porteuse Sₚ modulée par le signal de commande de sens S_{fonc} de la figure 3a, l'autre à la porteuse Sₚ modulée par le signal complémentaire du signal de la figure 3a.

Ces signaux S_{sens 1} et S_{sens 2} commandent chacun une paire d'interrupteurs, qui doivent être ouverts ou fermés simultanément. Le signal S_{sens 1} commande les interrupteurs Q1 et Q2. Le signal S_{sens 2} commande les interrupteurs Q3 et Q4.

A cet effet, le signal S_{sens 1} est envoyé sur les primaires de deux transformateurs T1 et T2, tandis que le signal S_{sens 2} est envoyé sur les primaires de deux transformateurs T3, T4 (figure 2).

Les secondaires de ces transformateurs T1 à T4 alimentent la tension grille-source des transistors Q1 à Q4, par l'intermédiaire chacun d'un montage M1, M4 qui assure les fonctions suivantes :
- filtrage du signal de commande Haute Fréquence reçu et maintien de la tension Vgs entre la grille et la source du transistor au-dessus d'une tension +V d'état passant, lorsqu'un signal Haute Fréquence de commande de sens est présent (fonctions symbolisées par l'unité F sur la figure 2),
- coupure rapide de la tension Vgs grille-source dudit transistor lorsque ce signal disparaît, le transistor étant alors à l'état bloqué (fonction symbolisée par l'unité C),
- protection dudit transistor Q1 à Q4 contre la saturation des transformateurs T1 à T4 (fonction symbolisée par l'unité P).

Un exemple de montage possible pour la commande d'un interrupteur Q par l'un des signaux S_{sens 1}, S_{sens 2}, a été représenté sur la figure 4. Le transformateur intermédiaire y a été référencé par T.

Le primaire dudit transformateur T est relié :
- d'un côté à une source de tension positive +Vcc (+ 12 Volts),
- de l'autre au neutre, par l'intermédiaire d'un interrupteur rapide Q11 commandé par l'un des signaux Haute Fréquence S_{sens 1}, S_{sens 2} en sortie de l'unité de modulation 8.

Cet interrupteur Q11 est par exemple un transistor MOS, dont la grille reçoit ledit signal Haute Fréquence S_{sens 1}, S_{sens 2}.

L'enroulement secondaire du transformateur T est d'un côté relié à l'anode d'une diode D1 dont la cathode est reliée à une résistance R1. A son extrémité opposée, la résistance R1 est reliée à la grille du transistor Q. Un condensateur C3 est monté en parallèle entre la cathode et l'anode de la diode D1.

L'autre extrémité de l'enroulement secondaire du transformateur T est reliée à la source d'un transistor Q12 de type MOS. La grille de ce transistor Q12 est reliée à un point N1 entre l'enroulement secondaire et la diode D1, par l'intermédiaire d'un circuit qui comprend en série une résistance R3, une diode Zener Z3 et une diode D3. La diode D3 est passante de la grille du transistor Q12 vers l'enroulement secondaire, la diode Zener Z3 étant montée en opposition.

La grille de ce transistor Q12 est également reliée à une résistance R2, dont l'extrémité opposée au transistor Q12 est reliée à la cathode d'une diode D2, dont l'anode est reliée au point N1 précité.

Un condensateur C1 est monté entre, d'une part, un point N2 entre la diode D2 et la résistance R2 et, d'autre part, la source du transistor Q12.

Un condensateur C2 est monté entre la grille et la source du transistor Q12.

Comme on l'aura compris, le transformateur T est monté en "Flyback" : il se charge lorsque l'interrupteur Q11 est ouvert.

Tant que le signal Haute Fréquence est présent, le fonctionnement est le suivant.

Lorsque l'interrupteur Q11 est fermé, l'énergie du primaire du tranformateur T est transférée à l'enroulement secondaire et la grille du transistor Q se charge alors par l'intermédiaire de la diode D1 et la résistance R1.

Les éléments R3, Z3 et D3 maintiennent alors une tension négative aux bornes du condensateur C2 et sur la grille du transistor Q21.

Le condensateur C1 se charge à une valeur initiale.

Lorsque Q11 s'ouvre à nouveau, le condensateur C1 a tendance à recharger le condensateur C2 à travers la résistance R2.

On choisit C1, R2 et C2 de façon que la tension aux bornes de C2 soit empêchée de remonter à une valeur positive suffisante pour faire conduire Q21 en une demi-période du signal Haute Fréquence.

La grille du transistor Q reste donc chargée tant que la porteuse haute fréquence est présente.

Lorsque le signal Haute Fréquence disparaît, le condensateur C2 se charge à la même tension que le condensateur C1.

Le transistor Q21 conduit et court-circuite la grille du transistor Q, qui est ainsi maintenu ouvert jusqu'à la réapparition de la porteuse haute fréquence.

On notera que le montage de conversion du circuit secondaire de la figure 4 :
- qui comporte des premiers moyens capacitifs C2 fournissant à l'interrupteur Q12 sa tension de commande et des deuxièmes moyens capacitifs C1, qui se chargent lorsque la tension haute fréquence est délivrée au circuit primaire et se déchargent dans lesdits premiers moyens capacitifs C2 lorsque ladite tension haute fréquence disparaît, de sorte que lesdits premiers moyens capacitifs C2 maintiennent alors ledit interrupteur Q12 fermé ;
- et dans lequel lesdits premiers et deuxièmes moyens capacitifs C1, C2, R2 sont choisis de façon que les premiers moyens ne soient pas suffisamment rechargés pour commander la fermeture dudit interrupteur Q12 en une demi-période de la tension haute fréquence, est particulièrement avantageux compte tenu notamment de sa simplicité.

Un montage détaillé d'un dispositif de commande intégrant des montages du type de celui de la figure 4 a été illustré sur la figure 5.

L'unité de modulation 8 y est constituée de quatre portes logiques de type NAND référencées de PL1 à PL4.

Les portes logiques PL1 et PL2 reçoivent toutes deux sur une première entrée le signal Sp correspondant à la porteuse Haute Fréquence (2 MHz par exemple). La porte PL1 reçoit sur sa deuxième entrée le signal de commande de sens S_{fonc} de la figure 3a, tandis que la porte PL2 reçoit le signal complémentaire.

Les signaux en sortie des portes PL1 et PL2 sont envoyés en entrée respectivement des portes PL3 et PL4 avec une tension de contrôle Vccl.

Les signaux en sortie des portes PL3 et PL4 correspondent aux signaux S_{sens 1} et Sₛₑₙₛ 2 des figures 3b et 3c.

Ces différentes portes logiques PL1 à PL4 sont de type IC7 74 HC00D.

Les sorties des portes PL3 et PL4 sont envoyées sur des circuits de filtrage comportant une résistance R10 de 47 Ohms en série avec une inductance L1 de 3,30 Henri, ainsi qu'un condensateur C11 de capacité égale à 100 picofarads monté entre le neutre et un point en sortie du circuit.

Les sorties de ces circuits de filtrage sont envoyées sur la grille de deux transistors MOS de type MMT 960 qui correspondent au transistor Q11 de la figure 4.

Les sources de ces deux transistors Q11 sont reliées au neutre. Le drain de chacun de ces deux transistors Q11 est relié aux enroulements primaires de deux transformateurs T par l'intermédiaire d'une résistance R11 de 120 Ohms. Des condensateurs C12 présentant une capacité de 200 picofarads sont également montés en dérivation entre les drains desdits transistors Q11 et le neutre.

A leurs autres extrémités, les enroulements primaires des quatre transformateurs T sont reliés par un noeud commun, d'une part, à une source de tension +V par l'intermédiaire de trois résistances R12 chacune de 33 Ohms, montées en parallèle, et, d'autre part, à un condensateur C13, qui présente une capacité de 0,47 microfarad et qui est relié au neutre à son autre extrémité.

Les quatre transformateurs T sont de type 23Z100SM et présentent un encombrement réduit.

Les enroulements secondaires de ces différents transformateurs T alimentent respectivement les quatre tensions grille-source des quatre transistors Q1 à Q4 (non représentés sur la figure 5), par l'intermédiaire des quatre circuits secondaires du type de celui illustré sur la figure 4.

La résistance R3 qui est de 220 Ohms.

La diode Zener Z3 est de type BZXB4C4D3.

La diode D3 est de type BAS16.

Le condensateur C2 présente une capacité de 220 picofarads.

La résistance R2 est de 22 kOhms.

Le condensateur C1 est d'une capacité de 0,1 microfarad.

La résistance R1 est de 47 Ohms.

Le condensateur C3 est de 100 picofarads.

Le circuit de commande qui vient d'être décrit à titre d'exemple est d'un encombrement : il tient dans un boîtier de 16 cm³.

D'autres variantes de l'invention sont bien entendu possibles. En particulier, la tension + V ou Vcc peut être fournie par le convertisseur DC/DC afin de s'affranchir des variations de tension de la batterie.

Comme on l'aura compris, le dispositif de commande selon l'invention comporte donc avantageusement les différentes caractéristiques suivantes prises seules ou selon toutes leurs combinaisons techniquement possibles :
- la tension haute fréquence délivrée au circuit primaire est modulée en amplitude, les moyens que comporte le circuit secondaire convertissant ladite tension haute fréquence en une tension d'ouverture ou de fermeture de l'interrupteur, selon l'amplitude de ladite tension haute fréquence,
- l'interrupteur étant un transistor de type MOS, le circuit secondaire comporte des moyens pour maintenir la tension grille-source dudit transistor au-dessus d'une tension de fermeture, lorsqu'une tension haute fréquence est délivrée au circuit primaire et pour décharger la grille dudit transistor, lorsque ladite tension haute fréquence disparaît,
- le circuit secondaire comporte un interrupteur monté entre la grille et la source du transistor du convertisseur continu/alternatif, ledit interrupteur étant ouvert lorsqu'une tension haute fréquence est délivrée au circuit primaire et court-circuitant la grille et la source dudit transistor lorsque ladite tension haute fréquence disparaît,
- le circuit secondaire comporte des premiers moyens capacitifs fournissant à l'interrupteur sa tension de commande et des deuxièmes moyens capacitifs, qui se chargent lorsque la tension haute fréquence est délivrée au circuit primaire et se déchargent dans lesdits premiers moyens capacitifs lorsque ladite tension haute fréquence disparaît, de sorte que lesdits premiers moyens capacitifs maintiennent alors ledit interrupteur fermé,
- lesdits premiers et deuxièmes moyens capacitifs sont choisis de façon que les premiers moyens ne soient pas suffisamment rechargés pour commander la fermeture dudit interrupteur en une demi-période de la tension haute fréquence,
- le circuit primaire est alimenté par une source de tension continue et comporte un interrupteur dont l'ouverture et la fermeture sont commandées par un signal modulé correspondant à la tension haute fréquence,
- le dispositif est un dispositif pour la commande d'un convertisseur continu/alternatif comportant quatre interrupteurs commandés montés selon un pont en H.

L'invention concerne également un dispositif d'alimentation d'une lampe à décharge de projecteur de véhicule automobile comportant un convertisseur continu/continu alimenté par exemple par la batterie du véhicule, un convertisseur continu/alternatif alimenté par le convertisseur continu/continu, un dispositif pour la commande du convertisseur continu/alternatif, caractérisé en ce que ce dispositif de commande est constitué par un dispositif du type précité.

L'invention concerne également un projecteur de véhicule automobile du type à lampe(s) à décharge, caractérisé en ce que la (ou les) lampes à décharge sont alimentée(s) par un dispositif d'alimentation du type précité.

## Revendications

1. Dispositif pour la commande d'un convertisseur continu/alternatif d'un dispositif d'alimentation d'une lampe à décharge (3) de projecteur de véhicule automobile, comportant un circuit primaire, des moyens (B) pour l'alimentation en tension de ce circuit primaire, ainsi qu'un circuit secondaire couplé par induction mutuelle à ce circuit primaire, ce circuit secondaire délivrant à un interrupteur (Q, Q1 à Q4) du convertisseur continu/alternatif une tension commandant sa fermeture ou son ouverture, caractérisé en ce que la tension que les moyens d'alimentation (7, 8) délivrent au circuit primaire consiste en une tension (Sₛₑₙₛ₁, Sₛₑₙₛ₂) à porteuse haute fréquence modulée, le circuit secondaire comportant des moyens (M1 à M4) pour convertir la tension haute fréquence délivrée au circuit primaire en une tension de commande (Vgs) de l'interrupteur (Q, Q1 à Q4) qui est supérieure ou inférieure à un seuil donné d'ouverture ou de fermeture, selon la modulation de ladite tension haute fréquence.

2. Dispositif selon la revendication 1, caractérisé en ce que la tension haute fréquence délivrée au circuit primaire est modulée en amplitude, les moyens (M1 à M4) que comporte le circuit secondaire convertissant ladite tension haute fréquence en une tension d'ouverture ou de fermeture de l'interrupteur (Q, Q1 à Q4), selon l'amplitude de ladite tension haute fréquence.

3. Dispositif selon la revendication 2, caractérisé en ce que l'interrupteur étant un transistor de type MOS, le circuit secondaire comporte des moyens pour maintenir la tension grille-source dudit transistor au-dessus d'une tension de fermeture, lorsqu'une tension haute fréquence est délivrée au circuit primaire et pour décharger la grille dudit transistor, lorsque ladite tension haute fréquence disparaît.

4. Dispositif selon la revendication 2, caractérisé en ce que le circuit secondaire comporte un interrupteur (Q12) monté entre la grille et la source du transistor (Q, Q1 à Q4) du convertisseur continu/alternatif, ledit interrupteur (Q12) étant ouvert lorsqu'une tension haute fréquence est délivrée au circuit primaire et court-circuitant la grille et la source dudit transistor (Q, Q1 à Q4) lorsque ladite tension haute fréquence disparaît.

5. Dispositif selon la revendication 4, caractérisé en ce que le circuit secondaire comporte des premiers moyens capacitifs (C2) fournissant à l'interrupteur (Q12) sa tension de commande et des deuxièmes moyens capacitifs (C1), qui se chargent lorsque la tension haute fréquence est délivrée au circuit primaire et se déchargent dans lesdits premiers moyens capacitifs (C2) lorsque ladite tension haute fréquence disparaît, de sorte que lesdits premiers moyens capacitifs (C2) maintiennent alors ledit interrupteur (Q12) fermé.

6. Dispositif selon la revendication 5, caractérisé en ce que lesdits premiers et deuxièmes moyens capacitifs (C1, C2, R2) sont choisis de façon que les premiers moyens ne soient pas suffisamment rechargés pour commander la fermeture dudit interrupteur (Q12) en une demi-période de la tension haute fréquence.

7. Dispositif selon l'une des revendications précédentes, caractérisé en ce que le circuit primaire est alimenté par une source de tension continue (+VCC) et comporte un interrupteur (Q11) dont l'ouverture et la fermeture sont commandées par un signal modulé (Sₛₑₙₛ₁, Sₛₑₙₛ₂) correspondant à la tension haute fréquence.

8. Dispositif pour la commande d'un convertisseur continu/alternatif (2) comportant quatre interrupteurs (Q1 à Q4) commandés montés selon un pont en H, caractérisé en ce qu'il est constitué par un dispositif selon l'une des revendications précédentes.

9. Dispositif d'alimentation d'une lampe à décharge de projecteur de véhicule automobile comportant un convertisseur continu/continu (1) alimenté par exemple par la batterie du véhicule, un convertisseur continu/alternatif (2) alimenté par le convertisseur continu/continu (1), un dispositif (6) pour la commande du convertisseur continu/alternatif (2), caractérisé en ce que ce dispositif de commande est constitué par un dispositif selon l'une des revendications précédentes.

10. Projecteur de véhicule automobile du type à lampe(s) à décharge, caractérisé en ce que la (ou les) lampe(s) à décharge (3) sont alimentée(s) par un dispositif d'alimentation selon la revendication 9.
